(19) Europäisches Patentamt

European Patent Office

Office européen des brevets

(11) **EP 1 715 505 A1**

(12) **EUROPEAN PATENT APPLICATION**

(43) Date of publication:
**25.10.2006 Bulletin 2006/43**

(51) Int Cl.:
*H01J 37/32* (2006.01)   *C23C 14/00* (2006.01)
*H05H 1/18* (2006.01)

(21) Application number: **05008521.6**

(22) Date of filing: **19.04.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(71) Applicant: **Max-Planck-Gesellschaft zur
Förderung
 der Wissenschaften e.V.
80539 München (DE)**

(72) Inventor: **Annaratone, Beatrice Maria
81925 München (DE)**

(74) Representative: **Hertz, Oliver
v. Bezold & Sozien
Patentanwälte
Akademiestrasse 7
80799 München (DE)**

(54) **Method and device for manipulating particles in plasma**

(57)   A method for manipulating particles in a plasma device (100) including at least one manipulator electrode (31, 32), comprises the steps of generating a plasma (1) and subjecting the manipulator electrode (31, 32) to a high frequency manipulation voltage for manipulating particles contained in the plasma (1), wherein at least one of a manipulation voltage frequency of the manipulation voltage and a plasma sheath resonance frequency of the plasma is adjusted so that both frequencies have a predetermined relationship. A plasma device (100) for carrying this method out is described.

FIG. 1

**Description**

The present invention relates to a method for manipulating particles, which are contained in a plasma and in particular to a method for manipulating particles by the influence of at least one manipulator electrode being capable to condition the plasma, e.g. by shaping the distribution of the DC and RF field in the plasma. Furthermore, the invention relates to a plasma device for manipulating particles in plasma and in particular to a plasma device comprising at least one manipulator electrode for shaping the electric field in the plasma.

It is generally known that gases that are energetically excited form plasma. Depending on the operation conditions, the plasma may contain particles in a suspended state. As an example, particles having typical dimensions in the nm- or $\mu$m-range can grow in the plasma, or particles can be injected into the plasma for processing or for investigating the plasma or the plasma sheath structure. The particles can move in the plasma in dependence on the superposition of several forces, e. g. electrical forces and gravity. Generally, there is an interest in moving particles in a predetermined way, e.g. for collecting the particles on a substrate or for repelling them from a substrate or for forming structures like so-called plasma crystals or aggregates.

In the publication "Complex-plasma manipulation by radio frequency biasing" (in "Plasma Phys. Control. Fusion" vol. 46, 2004, p. B495 - B509), B. M. Annaratone et al. describe the manipulation of particles in a plasma by using one flat-shaped electrode for influencing the electrical field in the plasma and in the plasma sheath. A high frequency voltage with adjustable amplitude and phase developing a controlled DC bias voltage was applied to the flat-shaped electrode with the result that particles were repelled from or attracted to the electrode depending on the bias voltage. The particle motion obtained with the manipulation voltage has a typical range of about 3 mm to 4 mm. This relative small distance range covered by the particle motion may represent a disadvantage for practical applications. As an example, if the particles were moved away from a substrate for avoiding a contamination, an increased motion range would be desired. Similarly, an increased motion range would be of interest for manipulating large numbers of particles in practical plasma devices.

It is the object of invention to provide an improved method for manipulating particles in plasma, wherein the method is capable of avoiding the disadvantages of the previous manipulation technique. Furthermore, the object of the invention is to provide an improved method being capable of manipulating particles with increased efficiency and reliability, in particular by providing an increased and/or controllable motion range. Furthermore, the object of invention is to provide an improved plasma device being capable of implementing the above manipulation method.

A method and a plasma device comprising the features of claims 1 and 9, respectively, solve this object. Advantageous embodiments and applications of the invention are defined in the dependent claims.

According to a first aspect, the invention bases on the general teaching of providing a method for manipulating particles in plasma with at least one manipulator electrode subjected to a high frequency (radio frequency) manipulation voltage. The manipulator electrode is arranged in or adjacent to the plasma, so that a plasma sheath is formed at the boundary between the surface of the manipulator electrode and the plasma. The at least one manipulator electrode is preferably provided in combination with a counter electrode being grounded or driven with opposite phase relative to the manipulator electrode. The counter electrode is provided e.g. by a chamber wall or another electrode. The system has a characteristic plasma-sheath resonance frequency. According to the invention, the frequency of the manipulation voltage or the plasma-sheath resonance frequency (or both of them) are adjusted in relation to each other. The inventor has found that the effect of particle manipulation can be quantitatively controlled and essentially increased if the manipulation voltage frequency and the plasma-sheath resonance frequency have a predetermined relationship, i.e. a predetermined frequency distance (which may be zero).

The manipulation voltage frequency is adjusted by controlling the operation frequency of a manipulation voltage source. On the other hand, the plasma-sheet resonance frequency can be adjusted by changing operation conditions of a plasma device for generating the plasma, in particular by changing at least one of the gas density, a spacing or position of plasma electrodes, the amplitude of the plasma operation voltage for generating the plasma and other plasma parameters. Preferably, the manipulation voltage frequency is adjusted while the plasma-sheath resonance frequency is kept constant. In this case, there are advantages in that the control of particle manipulation is facilitated and the operation conditions of the plasma device can be maintained in dependence on the particular application.

The adjustment of the manipulation voltage frequency and the plasma-sheath resonance frequency relative to each other represents an essential advantage in that the application range of particle manipulation in plasma devices is extended. The adjustment allows a quantitative determination of the motion range of the particles, so that particles can be moved in the plasma with improved reproducibility and reliability, e.g. for purposes as particle investigation or plasma processing or particle removal.

According to a preferred embodiment of invention, the frequency adjustment is performed such that both manipulation voltage frequency and plasma-sheath resonance frequency are in resonance to each other, i.e. they are equal to each other. As a result of this resonance, increased displacements of particles in the plasma can be obtained. This represents an essential advantage in terms of avoiding particle contaminations or removing particle fog in the plasma.

According to an alternative embodiment of the invention, the above frequencies are different from each other and the frequency adjustment provides a predetermined frequency spacing between the manipulation voltage frequency and the plasma-sheath resonance frequency. As the particle displacement is directly related to the frequency spacing, this embodiment of the invention allows a quantitative determination of the particle motion.

Generally; in the absence of particles the plasma-sheath resonance frequency can be estimated on the basis of theoretical considerations as described by B. N. Annaratone et al. in the publication "Identification of plasma-sheath resonances in a parallel-plate plasma reactor" (J. Appl. Phys. Vol. 77, 1995, p. 5455-5457). Subsequently, the manipulation voltage frequency can be selected on the basis of the theoretical plasma-sheath resonance frequency on the basis of parameters of the particle containing plasma. Alternatively, the plasma-sheath resonance frequency and in particular the resonance condition of the manipulation voltage frequency and the plasma-sheath resonance frequency can be obtained from a practical investigation of the plasma. Therefore, according to a further preferred embodiment of the invention, a step of monitoring the plasma is provided for obtaining operation conditions at which the intended frequency adjustment, in particular frequency resonance is obtained. This monitoring can comprise e.g. optical measurements, Langmuir probes, external electrical measurements etc..

Accordingly, with a further embodiment of the invention, the frequency resonance is identified by scanning the frequency of the manipulator together with a visual observation, optical measurement or another measurement of test particles in the plasma for detecting e.g. the resonance condition to be obtained.

Preferably, the manipulator electrode in attraction can be connected via an inductance with ground potential. Electrons attracted to the manipulator electrode can be conducted via the inductance to the ground potential so that the negative potential of the manipulator electrode can be avoided. The circuit provided by the manipulator electrode and the inductance is indicated here as an "inductance circuit". The inductance can be replaced by a choke or a selective filter (RF filter).

According to an advantageous embodiment of the invention, a step of controlling the inductance circuit is provided in order to set predetermined operation conditions. Preferably, a switch contained in the inductance circuit is controlled for closing or opening the inductance circuit. Furthermore, a DC voltage source is preferably contained in the inductance circuit. In this case, the amplitude of the DC voltage portion in the manipulation voltage is set by controlling the DC voltage source and particles can be removed permanently from the manipulator electrode. As a result, cleaning of the plasma for removing particles is obtained.

According to a second aspect, the present invention is based on the general technical teaching of providing a plasma device comprising at least one manipulator electrode for manipulating particles in the plasma under the influence of electrical fields and an adjustment device being adapted for adjusting at least one of the above manipulation voltage frequency and plasma-sheath resonance frequency. The adjustment device represents an essential advantage in that conventional plasma devices simply can be adapted for implementing the method of the invention. Preferably, the adjustment device is included in at least one of the voltage sources providing the manipulation voltage and the plasma operation voltage. With this embodiment, the adjustment device can be provided without a structural change of the plasma device. According to a particularly preferred embodiment of the invention, the manipulator electrode is connected with a manipulation voltage source containing a tuneable broadband amplifier. Advantageously, this manipulation voltage source with variable (tuneable) frequency is capable to provide the adjusted manipulation voltage required for particle manipulation in the plasma. The plasma device is e.g. a DC or RF plasma device, a microwave plasma device, a magnetron plasma device, or a plasma device with inductive coupled plasma.

According to a preferred embodiment of the invention, the manipulator electrode can be movable in the plasma device, in particular relative to the plasma or plasma edges. This embodiment may have advantages with regard to tuning the frequencies for obtaining the above resonance frequency and/or collecting an increased amount of particles.

An important advantage of the invention is given by the flexibility and broad application range of particle manipulation. In particular, particles in different portions of the plasma can be manipulated with the at least one manipulator electrode arranged in an appropriate position relative to the plasma. Alternatively, the frequency of the manipulator electrode is adjusted to the plasma sheath resonance corresponding to different paths for the RF current.

Generally, the plasma device is equipped with a plasma generator for generating the plasma which may include plasma electrodes for generating a plasma and/or another type of plasma generator comprising at least one of a radiation source, a particle beam source, an afterglow generator and a device for inductively generating the plasma.

If the manipulator electrode is arranged on one side of the plasma together with one of the plasma electrodes, the following advantages can be obtained. With a plasma device with horizontal plasma electrodes, the manipulator electrode can be positioned on the lower side of the plasma immediately adjacent to the lower plasma electrode or as an isolated and separately controllable portion within the lower plasma electrode. In this way, micron-sized particles subject to gravity and levitated in the lower plasma sheath, can be collected. Advantageously, conventional adaptive electrodes can be used for providing the combination of the lower plasma electrode and the manipulator electrode. According to an alternative embodiment, the manipulator electrode can be arranged with a distance from both plasma electrodes adjacent to a space in which the plasma is generated. In this case, the cleaning efficiency of the particle manipulation in the particle nano-size range (fog) can be improved.

According to a further modification of the invention, the plasma device comprises the inductance circuit including the manipulator electrode and an inductance for connecting the manipulator electrode with DC potential if necessary.

Further details and advantages of the invention are described in the following with reference to the attached drawings, which show:

Figure 1:       a sectional view of a plasma device according to the invention;

Figure 2:       a schematic illustration of the arrangement of the manipulator electrode in a plasma device;

Figures 3, 4:    examples of inductance circuits provided according to embodiments of the invention;

Figures 5, 6:    further schematic illustrations of the arrangement of the manipulator electrode in a plasma device;

Figure 7:       a graphical representation of the resonance effect used according to a preferred embodiment of the invention; and

Figure 8:       a photograph illustrating the particle manipulation according to an embodiment of the invention.

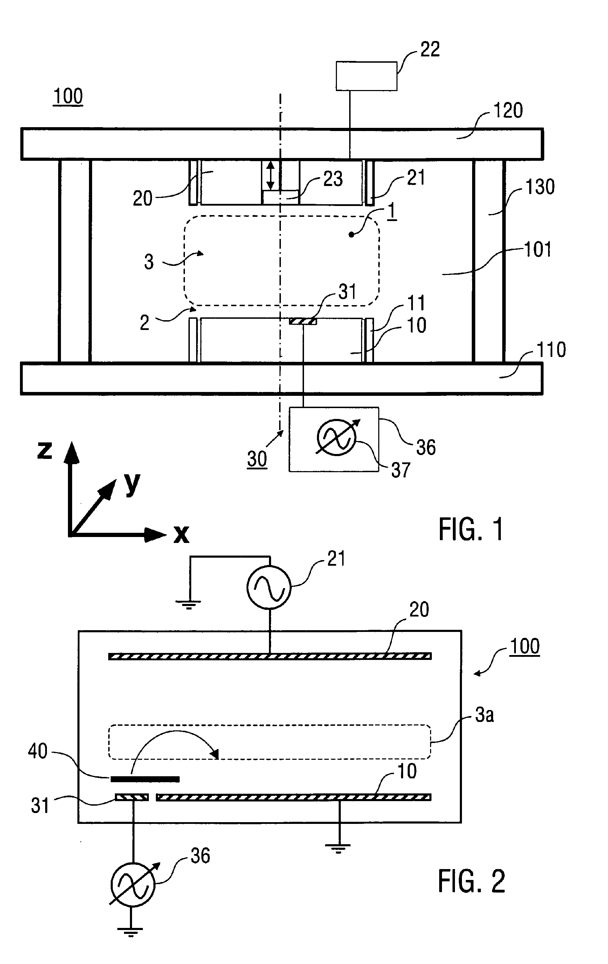

In the following, embodiments of the invention are described with reference to a parallel plate radio frequency plasma reactor 100 as schematically shown in Figure 1. It is emphasized that the invention can be implemented in an analogue way with modified plasma devices as used in particular in semiconductor and solar cell technology, or generally in other DC or RF plasma devices, microwave plasma devices, magnetron plasma devices, electron cyclotron devices, plasma devices with inductive coupled plasma etc. independently of the presence of magnetic fields. Furthermore, exemplary reference is made to a plasma reactor operated at reduced pressure. The invention can be implemented in an analogue way at higher pressure, in particular at reduced atmospheric pressure, e.g. for cleaning fumes.

The plasma reactor 100 of Figure 1 comprises a plasma chamber 101 formed by lower and upper parallel plates 110, 120 and a wall 130. The wall 130 is made of transparent, dielectric material, e.g. glass. Alternatively, it may be metallic with optional windows for monitoring the inner volume of the plasma chamber 101. The wall 130 may have a cylindrical shape. The plasma reactor 100 contains further components (not shown in the figure) as known from conventional plasma reactors, like e.g. vacuum connectors, gas injectors, substrate holder and/or monitoring and measuring devices.

Plasma electrodes 10, 20 are arranged at the lower and upper plates 110, 120. The plasma electrodes 10, 20 are electrically isolated from the plates 110, 120 by using electrode holders 11, 21. In this example, the upper electrode 20 (driven electrode) is connected with the plasma operation voltage source 22 containing an amplifier for a conventional plasma operation frequency, while the lower electrode 10 is connected with ground potential. A dust dispenser 23 being integrated into the upper plasma electrode 20 is movable in z-direction (see double arrow). The dust dispenser 23 is not a necessary feature of the invention but rather an auxiliary device for injecting particles into the plasma chamber 101.

According to the invention, the plasma reactor 100 contains a manipulator device 30 with at least one manipulator electrode 31 and at least one manipulation voltage source 36. Manipulation voltage source 36 contains a tuneable power amplifier 37 allowing an adjustment of the electrical parameters of the manipulator electrode 31. In particular, the broadband amplifier 37 is adapted to adjust the frequency of the manipulation voltage. Further details of the manipulation device 30 are described below with reference to Figures 2 to 6.

The plasma reactor 100 has e.g. the following dimensions. Diameter of the plasma chamber 101: 10 cm; distance of the lower and upper plates 110, 120: 5...10 cm; diameter of the plasma electrode 10, 11: 4 cm; perpendicular distance between the surfaces of the plasma electrodes 10, 20 (plasma space): 3 cm; diameter of the manipulator electrode 31: 3...4 mm. These values represent examples only. The dimensions and geometrical shapes can be changed in dependence on the particular application of the plasma reactor. As an example, the dimensions can reach 1 m or more, in particular in the field of window coating technology. As a further example, the manipulator electrode can have a concave shape.

The lower plasma electrodes 10 with the manipulator electrode 31 can be provided by an adaptive electrode as described by B. M. Annaratone et al. in "Plasma Phys. Control. Fusion" vol. 46, 2004, p. B495 - B509). With regard to the structure of the plasma device and the operation thereof, this publication is introduced to the present specification by reference.

In the following, the operation of the plasma reactor 100 is described. If a high frequency operation voltage is applied to the electrodes 10, 20, the plasma 1 is generated in the operation gas (e.g.: Ar, O, $CF_4$, $SiH_4$, $SF_6$) contained in the plasma reactor 100. The plasma 1 is formed in the plasma space between the surfaces of the plasma electrodes 10, 20. It comprises positive ions, negative ions and electrons (negative charge) as well as particles that can be grown in the plasma or injected through the dust dispenser 23. The particles have typical dimensions in the range of 10 nm to 50 $\mu$m or higher. As an example, micro particles with a length of 0.6 mm and a diameter of 5 $\mu$m have been successfully manipulated according to the invention. Plasma 1 containing particles is called "complex plasma". Injected particles comprise e.g. silica, carbon, melamine-formaldehyde resins, plasma formed particles comprising carbon, sputtered materials or the like.

At the boundaries of the plasma space with the plasma electrodes 10, 20, plasma-sheath regions are formed. The plasma sheath 2 is a space charge region where the positive ions are predominant. At radio frequencies, the plasma-sheath behaves essentially as a capacitor, since the small number of electrons has a limited effect. On the other hand, the region 3 is essentially neutral, i.e. the density of positive ions is practically the same as that of the electrons (plus the negative charge of the particles and the charge carried by negative ions, if they are present). Under radiofrequency excitation with frequencies as high as the electron plasma frequency, the region 3 essentially behaves like an inductance.

During operation of the plasma reactor 100, a radio frequency current path is formed between the plasma electrodes 10, 20. This path can be described with an equivalent circuit containing the capacitors of the plasma-sheath 2 and the inductance of the plasma region 3. In this circuit, at certain frequencies, the plasma-sheath resonance takes place as it is described by B. N. Annaratone et al. in the publication "Identification of plasma-sheath resonances in a parallel-plate plasma reactor" (J. Appl. Phys. Vol. 77, 1995, p. 5455-5457).

For a plane geometry (as in Figure 1), the plasma-sheath resonance frequency can be calculated as follows.

$$f_R = f_{ep}/(1 + p/2s)^{1/2} \tag{1}$$

In equation (1), $p$ is the length of the current path in the plasma, $s$ is the sheath thickness and $f_{ep}$ is the electron plasma frequency of the plasma (or: complex plasma) according to:

$$f_{ep} = (1/2\pi)(e^2 n_e/\varepsilon_0 m) \tag{2}$$

with e and m being the charge and the mass of the electrons and no being the density of the free electrons.

In the present invention, a resonant circuit for the current is provided by the manipulator electrode and a counter electrode, which may be represented by a second manipulator electrode driven in opposite phase with respect to the first manipulator electrode, or by any electrode or plasma confining surface through which the radiofrequency current may close the loop. The manipulator electrode and the counter electrode may be covered by a dielectric material.

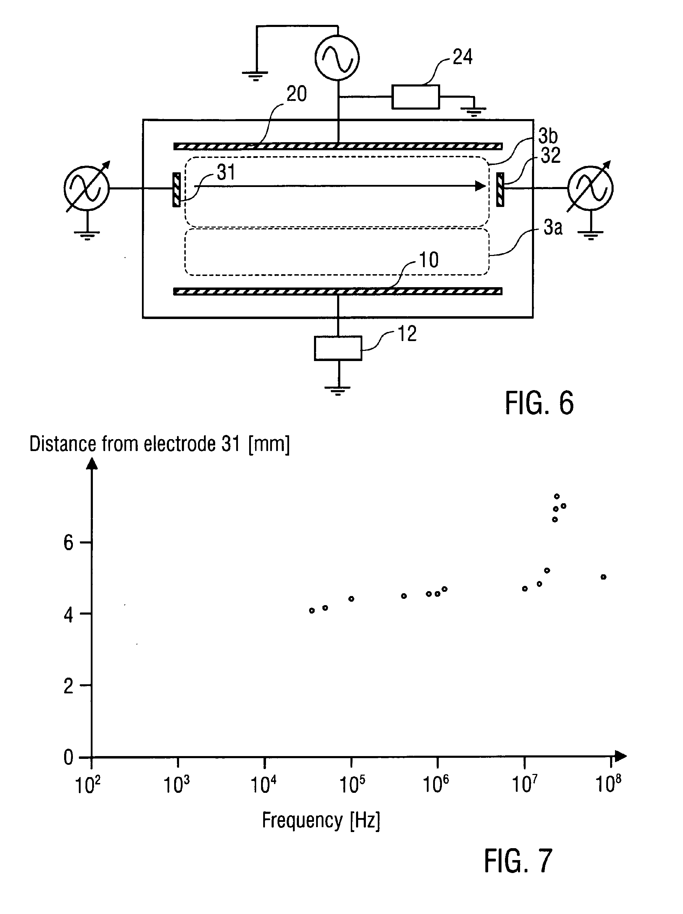

With a density of the complex plasma of $10^{13}$ m$^{-3}$, a sheath thickness of 2.7 mm and p = 3.8 mm, the resonance frequency is $f_R$ = 23 MHz (see below, Figure 7, the return path for the current is through the adjacent surface).

According to the invention, the manipulation frequency and the plasma sheath resonance frequency are adjusted relative to each other. The adjustment provides various manipulation functions described in the following with reference to Figures 2 to 6. All these manipulation functions are amplified when the manipulator electrode 31 is driven in plasma-sheath resonance (or correspondingly in complex-plasma-sheath resonance).

Several plasma sheath resonances may be present in a reactor according to the path of the RF current. In this case, the manipulation frequency is adjusted to the plasma sheath resonance frequency with an RF current path of interest.

Figure 2 illustrates a plasma device structured similar to the embodiment of Figure 1. The manipulator electrode 31 is arranged adjacent to the plasma electrode 10. A substrate 40 is arranged above the manipulator electrode 31. Complex plasma 3a (dashed line) is formed containing heavy particles above plasma electrode 10 and substrate 40. If the manipulation voltage frequency is selected to be equal to the plasma-sheath resonance frequency, e.g. in the range of 1 to 200 MHz, particles are strongly repelled from the manipulator electrode 31. An RF current path is formed through the complex plasma 3a from the manipulator electrode 31 to the grounded plasma electrode 10. The particles are moved along the RF current path to the surrounding regions as schematically illustrated with the curved arrow. Accordingly, particle-free plasma is obtained above the manipulator electrode 31 so that any plasma processing or depositing on the substrate 40 can take place without any contamination of the substrate 40 with particles.

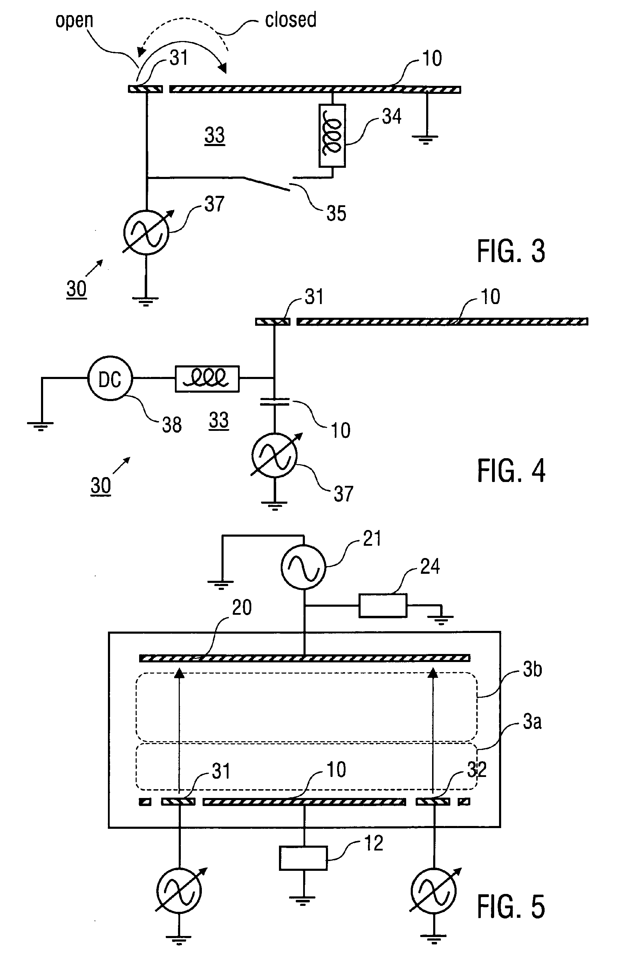

Further operation modes can be obtained if an inductance circuit 33 is provided according to one of the embodiments shown in Figures 3 and 4. According to Figure 3, the inductance circuit 33 comprises an inductance 34 and a switch 35. If the switch 35 is open, the manipulator electrode 31 operates as shown in Figure 2. Particles are repelled from the neighbourhood of the electrode. If the switch 35 is closed, the manipulator electrode 33 is connected via the inductance 34 with ground potential. In the illustrated embodiment, the inductance 34 is connected with the lower plasma electrode 10 that has ground potential. Alternatively, inductance 34 may be connected with another component having a ground potential (e.g. parts of the plasma reactor) if the plasma electrode should not have ground potential.

With the closed switch 35, electrons can flow to ground potential. In this case, a negative potential at the manipulator electrode is avoided. The manipulator electrode 31 functions as an anode. As the result, electrons are drawn from the plasma to the manipulator electrode 31. Other negative charged particles also move towards the manipulator electrode as illustrated with the dashed arrow.

The switch 35 is not a necessary feature of the inductance circuit 33. Alternatively, manipulator electrode 33 can be permanently connected via inductance 34 with ground potential.

Another modification of the inductance circuit 33 is illustrated in Figure 4. With the introduction of the DC voltage source 38 providing a bias voltage, the electron current from the manipulator electrode 31 to ground potential can be controlled. The bias voltage is preferably selected in the range of about 1 V to about 5 V (or of the order of the electron energy, $kT_e$). This voltage is normally lower than the plasma potential.

With the above manipulator operations, the following further function can be obtained. If the particles are attracted to the manipulator electrode 31, in particular to the substrate arranged above the manipulator electrode 31, this can result in a particle storing function. As an example, in a first phase of operation, particles can be attracted to the manipulator electrode 31 for storing them. In a second phase, the particles are repelled simply by opening the switch 35 (see Figure 3). As a result, the particles are re-injected into the plasma. With the introduction of a small DC voltage, e.g. 5 V, the particles are removed permanently from the plasma.

If a manipulation selective in different regions is to be obtained, more than one manipulator electrode can be provided in the plasma reactor 100. Preferably, each of the manipulator electrodes can be controlled separately so that e.g. a predetermined motion path can be defined by selecting the above repelling or attracting functions. The manipulator electrode(s) can be located at any surface exposed to the plasma. For small and medium size particles (about 100 nm up to about 1 $\mu$m), the position is independent of the directions of the system. For larger particles, the gravity is to be taken into consideration.

Figure 5 illustrates an embodiment with two manipulator electrodes 31, 32 integrated in the middle or in the side of the surface of the lower plasma electrode 10. The upper plasma electrode 20 is shorted with a pass filter 24 at the resonant frequency and the lower electrode has a choke 12 for this frequency. In this case, the RF current path runs through the whole plasma region to the upper plasma electrode (see arrows). The plasma region comprises a lower particle containing plasma 3a and a higher nano-particle complex plasma 3b. The frequency of the manipulation voltage applied to the manipulator electrode 31 or 32 is tuned to the complex plasma sheath resonance of the two plasma 3a, 3b together. In this case, particles are collected by the lower complex plasma as well as from the bulk plasma (nanoparticles).

According to Figure 6, the manipulator electrodes 31, 32 are arranged adjacent to a plasma space between the lower and upper plasma electrodes 10, 20. This arrangement is in particular suitable for removing suspended particles from the upper plasma region 3b with typical dimensions in the sub-$\mu$m-range (so-called "fog"). To this end, both electrodes 31, 32 are driven in opposite phase relative to each other. In this case nanoparticles dispersed in the plasma are collected while the lower particles (3a) are left in place.

The effect of adjustment of the manipulation voltage frequency and the plasma-sheath resonance frequency relative to each other is further illustrated in Figure 7. In this diagram, the displacement of the repelled particles above the manipulator electrode 31 is plotted against the frequency of the manipulation voltage. At the plasma-sheath frequency $f_R$ = 23 MHz, a resonance takes place so that the displacement is essentially increased. When the manipulator electrode is operated in resonant "attractive mode", the particles are collected from all the plasma volume. Furthermore, if this resonance condition is not fulfilled, certain displacement values can be set simply by the appropriate adjustment of both frequencies relative to each other or by varying the amplitude of the resonant voltage. Accordingly, the quantitative displacement parameters of the above manipulation operations can be adjusted by selecting an appropriate manipulation voltage frequency.

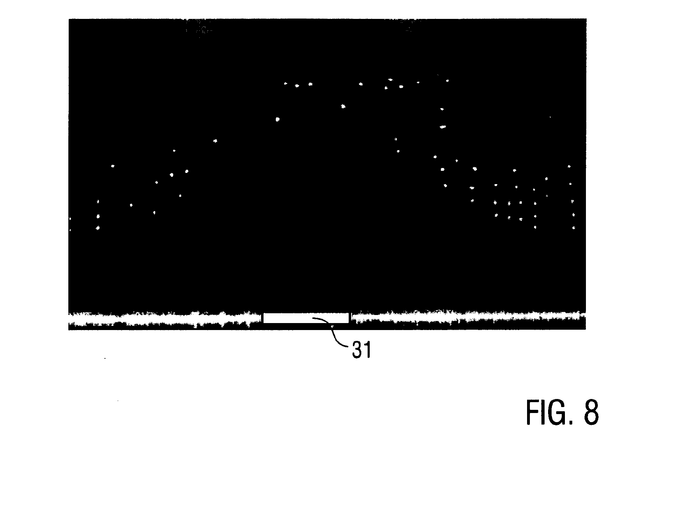

Figure 8 illustrates an example of repelling particles from the manipulator electrode (resonant manipulator electrode in repulsion) as obtained with the embodiment of Figure 2 with open switch 35.

## Claims

1. Method for manipulating particles in a plasma device (100) including at least one manipulator electrode (31, 32), comprising the steps of:

   - generating a plasma (1), and
   - subjecting the manipulator electrode (31, 32) to a high frequency manipulation voltage for manipulating particles contained in the plasma (1),

**characterized by** the steps of

- adjusting at least one of a manipulation voltage frequency of the manipulation voltage and a plasma sheath resonance frequency of the plasma so that both frequencies have a predetermined relationship.

2. Method according to claim 1, wherein at least one of the manipulation voltage frequency and the plasma sheath resonance frequency are adjusted such that both frequencies are equal to each other.

3. Method according to claim 1, wherein at least one of the manipulation voltage frequency and the plasma sheath resonance frequency are adjusted such that both frequencies have a predetermined frequency spacing.

4. Method according to claim 2 or 3, comprising the step of monitoring the plasma for obtaining operation conditions at which the manipulation voltage frequency and the plasma sheath resonance frequency have the predetermined relationship.

5. Method according to claim 4, comprising the step of scanning the manipulation voltage frequency until the resonance condition of the manipulation voltage frequency and the plasma sheath resonance frequency has been found.

6. Method according to at least one of the foregoing claims, comprising the step of providing the manipulation voltage with a DC voltage portion.

7. Method according to at least one of the foregoing claims, further comprising the step of controlling an inductance circuit (33) or an RF filter circuit comprising the manipulator electrode (31, 32) and an inductance (34) or an RF filter being capable to connect the manipulator electrode (31, 32) with ground potential.

8. Method according to claim 6, wherein the connection of the manipulator electrode (31, 32) with ground potential is controlled by operating a switch (35) contained in the inductance circuit (33).

9. Plasma device (100) comprising:

- at least one manipulator electrode (31, 32) for manipulating particles in a plasma, the manipulator electrode (31, 32) being connected with a high frequency manipulation voltage source (36),

**characterized by**

- an adjustment device (37) for adjusting at least one of a manipulation voltage frequency of the manipulation voltage and a plasma sheath resonance frequency of the plasma so that both frequencies have a predetermined relationship.

10. Plasma device according to claim 9, wherein the adjustment device (37) is included in at least one of the manipulation voltage source (36) and the plasma operation voltage source (22).

11. Plasma device according to claim 10, wherein the adjustment device (37) comprises a tuneable broadband amplifier included in the manipulation voltage source (36).

12. Plasma device according to at least one of the foregoing claims 9 to 11, further comprising:

- an inductance circuit (33) or an RF filter circuit including the manipulator electrode (31, 32) and an inductance (34) or an RF filter being capable to connect the manipulator electrode (31, 32) with ground potential.

13. Plasma device according to at least one of the foregoing claims 9 to 12, wherein the at least one manipulator electrode (31, 32) is movable in the plasma device.

14. Plasma device according to at least one of the foregoing claims 9 to 13, further comprising plasma electrodes (10, 20) for generating the plasma in the plasma device (100), the plasma electrodes (10, 20) being connected with a plasma operation voltage source (22).

15. Plasma device according to claim 14, wherein the manipulator electrode (31, 32) is arranged adjacent to or surrounded by one of the plasma electrodes (10, 20).

16. Plasma device according to at least one of the foregoing claims 14 to 15, wherein the manipulator electrode (31, 32) is arranged adjacent to a space between the plasma electrodes (10, 20).

17. Plasma device according to at least one of the foregoing claims 9 to 16, further comprising a plasma generator for generating the plasma in the plasma device (100), the plasma generator comprising at least one of a radiation source, a particle beam source, an afterglow generator and a device for inductively generating the plasma.

FIG. 1

FIG. 2

open                    closed

31

10

33          34

35

37

30          FIG. 3

31                      10

DC          lll

38          33          10

37

30          FIG. 4

21          24

20          3b

3a

31          10          32

12

FIG. 5

FIG. 6

Distance from electrode 31 [mm]

Frequency [Hz]

FIG. 7

31

FIG. 8

**European Patent Office**

**EUROPEAN SEARCH REPORT**

Application Number

EP 05 00 8521

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 102 496 A (SAVAS ET AL) 7 April 1992 (1992-04-07) * column 5, line 26 - line 60; claims 1,4,5; figure 4 * ----- | 1,9, 14-17 | H01J37/32 C23C14/00 H05H1/18 |
| X | US 5 849 372 A (ANNARATONE ET AL) 15 December 1998 (1998-12-15) * column 4, line 1 - line 28; claim 1; figure 2 * ----- | 1,9-13, 17 | |
| X | ANNARATONE B M: "Diagnosis of a plasma in plasma-sheath resonance" IEE COLLOQUIUM ON MEASUREMENT AND PLASMAS (DIGEST NO: 1997/088), 25 February 1997 (1997-02-25), pages 3-1, XP006509902 * Introduction - second paragraph * ----- | 1,2 | |

**TECHNICAL FIELDS SEARCHED** (Int.Cl.7)

H01J
C23C
H05H

The present search report has been drawn up for all claims

| Place of search | Date of completion of the search | Examiner |
|---|---|---|
| Munich | 22 September 2005 | Smith, C |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

     ....................................................................................

& : member of the same patent family, corresponding
 document

EPO FORM 1503 03.82 (P04C01)

**ANNEX TO THE EUROPEAN SEARCH REPORT
ON EUROPEAN PATENT APPLICATION NO.**                     EP 05 00 8521

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2005

| Patent document cited in search report | | Publication date | Patent family member(s) | Publication date |
|---|---|---|---|---|
| US 5102496 | A | 07-04-1992 | NONE | |
| US 5849372 | A | 15-12-1998 | NONE | |

EPO FORM P0459

s33333333

ss333333333333

s3333333333

**EP 1 715 505 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **B. M. ANNARATONE.** Complex-plasma manipulation by radio frequency biasing. *Plasma Phys. Control. Fusion,* 2004, vol. 46, B495-B509
- **B. N. ANNARATONE et al.** Identification of plasma-sheath resonances in a parallel-plate plasma reactor. *J. Appl. Phys.,* 1995, vol. 77, 5455-5457
- **B. M. ANNARATONE et al.** *Plasma Phys. Control. Fusion,* 2004, vol. 46, B495-B509